# EUROPÄISCHE PATENTSCHRIFT

(11) **EP 1 997 153 B1**
(45) Veröffentlichungstag und Bekanntmachung des Hinweises auf die Patenterteilung: **24.06.2015**
(21) Anmeldenummer: 07722831.0
(22) Anmeldetag: 15.02.2007
(51) Int. Cl.: H01L 31/052

(54) **PHOTOVOLTAISCHES KONZENTRATORMODUL MIT MUlTIFUNKTIONSRAHMEN**
PHOTOVOLTAIC CONCENTRAT OR MODULE WITH MULTIFUNCTION FRAME
MODULE CONCENTRATEUR PHOTOVOLTAÏQUE AVEC CADRE MULTIFONCTIONS

(30) Priorität: 17.02.2006 DE 102006007472
(43) Veröffentlichungstag der Anmeldung: 03.12.2008
(73) Patentinhaber: Fraunhofer-Gesellschaft zur Förderung der angewandten Forschung e.V., 80686 München (DE); Soitec Solar GmbH, 79111 Freiburg im Breisgau (DE)
(72) Erfinder: DIMROTH, Frank, 79194 Gundelfingen (DE); BETT, Andreas, 79114 Freiburg (DE); SCHMIDT, Christoph, 91710 Gunzenhausen (DE); LERCHENMÜLLER, Hansjörg, 79100 Freiburg (DE)
(74) Vertreter: Pfenning, Meinig & Partner GbR
(86) Internationale Anmeldenummer: PCT/EP2007/001326
(87) Internationale Veröffentlichungsnummer: WO 2007/093422

(56) Entgegenhaltungen:
- WO-A-01/75976
- WO-A-92/13362
- WO-A1-00/46860
- DE-A1-102004 027 527
- DE-U1- 20 219 221
- DE-U1- 20 320 412
- US-A- 4 834 805

## Beschreibung

Die Erfindung betrifft ein photovoltaisches Konzentratormodul mit Multifunktionsrahmen sowie ein Verfahren zu seiner Herstellung. Derartige Konzentratormodule werden insbesondere im Bereich der konzentrierenden Solartechnik verwendet. Das Dokument US 4834805 A beschreibt ein photovoltaischeis Konzentratormodul.

Bereits seit vielen Jahren gibt es in der Photovoltaik Ansätze, mit konzentrierter Solarstrahlung zu arbeiten. Das Prinzip ist einfach: Solarstrahlung wird mit Spiegeln und/oder Linsen konzentriert und auf spezielle Konzentrator-Solarzellen gerichtet. Damit reduziert sich die benötigte Fläche an teurem Zellmaterial. Die Konzentrator-Technologie steht nun vor einem entscheidenden Durchbruch. Dies nicht zuletzt deshalb, weil bei hocheffizienten Konzentrator-PV-Solarzellen auf III-V-Basis Zellwirkungsgrade von über 37 % erzielt wurden, und somit Modulwirkungsgrade von deutlich über 25% möglich werden. Die Anwendung von III-V Solarzellen in Konzentratorsystemen wird seit langem untersucht. Hierbei wird das Sonnenlicht mit Hilfe von Fresnel-Linsen um einen Faktor 300 bis 1000 auf einen winzigen Brennfleck fokussiert, in dem sich dann eine nur noch 2 bis 10 mm² kleine Solarzelle befindet. Der Sinn dieses Vorgehens ist es, die teure Halbleiterfläche der III-V Stapelzellen durch eine vergleichsweise günstige Optik zu ersetzen und dadurch die Anwendung dieser erfolgreichen Weltraumtechnologie auch auf der Erde gewinnbringend zu machen.

Solche konzentrierenden Photovoltaiksysteme dienen zur Stromerzeugung, insbesondere in photovoltaischen Kraftwerken. Hierzu werden eine Vielzahl von Modulen auf einer Nachführeinheit, einem so genannten Tracker, montiert, welche die Konzentratormodule immer zur Sonne hin ausrichtet. Die Module auf einer Nachführeinheit werden elektrisch miteinander verbunden. Diese noch sehr junge Technologie hat bei einer großflächigen Nutzung insbesondere die Vorteile, durch ein hohes Wirkungsgradpotential eine Kostenreduktion bei der photovoltaischen Stromerzeugung zu ermöglichen, bis in den Gigawatt Bereich ohne Rohstoffverknappung skalierbar zu sein und eine kurze energetische Amortisationszeit aufzuweisen.

Wegen der höheren Komplexität von konzentrierenden Photovoltaik-Systemen im Vergleich zu konventionellen Flachmodulen eignen sich erstere insbesondere für den Einsatz im Kraftwerksbereich. Ein gewisses Maß an Wartung ist wegen der geregelten Nachführung und einer möglichen Verschmutzung der Optik notwendig.

Die vorliegende Erfindung betrifft ein photovoltaisches Konzentratormodul zur Stromerzeugung, welches aus zwei Ebenen aufgebaut ist. Auf der oberen Ebene, im Folgenden als Linsenplatte bezeichnet, befindet sich ein optischer Konzentrator, welcher vorzugsweise eine Anordnung von punktfokussierenden Linsen in der Ebene der Linsenplatte enthält, vorzugsweise dergestalt, dass die Linsen einen möglichst großen Teil der Fläche des Konzentrators überdecken. Als Linsen kommen Fresnel-Linsen, aber auch sphärische Linsen infrage.

Auf der unteren Ebene, im Folgenden als Bodenplatte bezeichnet, befinden sich die Solarzellen inklusive deren elektrischer Verschaltung. Jede Solarzelle ist im Fokus je einer Linse angeordnet.

Wesentlich beim Aufbau dieser Konzentratormodule ist es, dass der Abstand der Linsenebene zur Bodenplatte sehr genau eingehalten wird, so dass das konzentrierte Licht vollständig auf die Fläche der Solarzelle trifft.

Ein typischer Konzentrator ist der FLATCON^{®} Konzentrator mit einer Linsenplatte mit Fresnel-Linsen, welche das Sonnenlicht um einen geometrischen Faktor von 500 auf Stapelzellen mit 2-3 pn-Übergängen aus III-V Halbleitern konzentrieren.

Die Bestandteile der Linsenplatte und der Bodenplatte werden jeweils vorzugsweise von einer Glasplatte getragen, aber auch andere Plattenmaterialien, wie zum Beispiel Acryl oder Plexiglas, sind möglich. Die beiden Glasplatten werden nach bisherigem Vorgehen durch vier rechteckige Glasplatten mit Silikon oder UVhärtendem Kleber derart verklebt, dass die vier Glasplatten einen Rahmen bilden, der am Rand der Linsen- und Bodenplatte umläuft oder sie werden mit Metallprofilen verschraubt, die am Rand der Linsen- und Bodenplatte umlaufen.

Diese Vorgehensweise hat mehrere Nachteile: Die Dichtfläche ist sehr klein und wurde nur mit einer einzigen Dichtmasse aus Silikon verklebt. Dadurch ist es nicht möglich, das Modul über Zeiträume von 20 Jahren und mehr dicht zu halten gegenüber Feuchtigkeitseintritt von außen. Dies ist sehr problematisch, da Feuchtigkeit zu einer Korrosion von Kontakten auf und zwischen den Solarzellen führen kann und dadurch die Langlebigkeit dieses Produkts beeinträchtigt. Die Fertigung solcher Glasrahmen aus mehreren Einzelteilen ist wirtschaftlich sehr ungünstig und kann nur schwer automatisiert werden. Schließlich lassen sich die in dieser Erfindung angegebenen zusätzlichen Komponenten wie Filter zur aktiven Belüftung, Sorptionsmittel, Modulbefestigung und elektrischer Durchführung in einem Glasrahmen nur schwer oder gar nicht realisieren.

Aufgabe der vorliegenden Erfindung ist es daher, ein photovoltaisches Konzentratormodul zu schaffen, welches kostengünstig hergestellt werden kann, langlebig ist, und das es erlaubt, einfach und flexibel zusätzliche Komponenten zu integrieren die auf der Linsenplatte oder der Bodenplatte nicht oder nur schwierig untergebracht werden können. Darüber hinaus soll ein Verfahren entwickelt werden, das die Herstellung solcher Konzentratormodule ermöglicht.

Diese Aufgaben werden durch das photovoltaische Konzentratormodul nach Anspruch 1 sowie das Verfahren nach Anspruch 14 gelöst. Vorteilhafte Weiterbilungen des erfindungsgemäßen Solarzellenmoduls und des erfindungsgemäßen Verfahrens zu seiner Herstellung werden in den jeweiligen abhängigen Ansprüchen gegeben.

Das erfindungsgemäße photovoltaische Konzentratormodul enthält als wesentliche Komponenten eine Linsenplatte, eine zur Linsenplatte parallele Bodenplatte, einen Rahmen, der zwischen der Linsenplatte und der Bodenplatte längs des Randes der Linsenplatte und der Bodenplatte umläuft, sowie eine erste Dichtmasse und/oder Klebmasse und eine zweite Dichtmasse, die zwischen der Linsenplatte und dem Rahmen und/oder zwischen der Bodenplatte und dem Rahmen entlang des Rahmens nebeneinander zumindest teilweise umlaufend angeordnet sind, wobei die beiden Dicht- und/oder Klebemassen sich bezüglich ihrer Aushärtezeiten und/oder Gasdurchlässigkeiten unterscheiden. Vorzugsweise bildet zumindest die zweite Dichtmasse eine Dichtlinie, im Prinzip kann aber jede Dichtmasse als Dichtlinie ausgeführt sein. Die Linsenplatte ist hierbei eine transparente Platte, zum Beispiel aus Glas, Acryl oder Plexiglas, auf welcher mindestens ein optischer Konzentrator angeordnet ist. Der optische Konzentrator enthält vorzugsweise punktfokussierende Linsen wie zum Beispiel Fresnel-Linsen oder sphärischen Linsen.

Diese Anordnung erlaubt es, den Abstand zwischen Linsen- und Bodenplatte sehr genau einzuhalten, so dass gewährleistet ist, dass die Solarzellen vom durch die Linsen gebündelten Licht vollständig ausgeleuchtet werden.

Die Bodenplatte trägt die Solarzellen sowie Teile ihrer Verschaltung, wobei sich das erfindungsgemäße Modul vor allem für die Verwendung mit Stapelzellen eignet.

Mindestens eine der zwei Dichtmassen, welche als Dichtlinien parallel zum Rand der Linsenplatte und/oder der Bodenplatte nebeneinander zumindest teilweise umlaufen, ist vorzugsweise dauerelastisch. Für die äußere dieser Dichtmassen eignet sich besonders ein elastisches Silikon, welches geeignet ist, Spannungen und Verformungen der verschiedenen Materialien aufzunehmen. Die innere Dichtmasse ist vorzugsweise eine Butylschnur, welche die luft- und/oder feuchtigskeitsdichte Verbindung der Komponenten des Konzentratormuduls und die Fixierung der Platten ermöglicht.

Treten beispielsweise die mechanischen Beanspruchungen durch eine andere Anordnung der Komponenten des erfindungsgemäßen Moduls an der inneren Dichtmasse auf, so kann auch die innere Dichtmasse Silikon enthalten oder daraus bestehen und die äußere Dichtmasse Butylschnur sein oder daraus bestehen.

Vorzugsweise läuft die, zum Beispiel Silikon enthaltende, zweite Dichtmasse neben der ersten Dichtmasse oder Klebmasse. Als Klebemasse kommen zum Beispiel Heißkleber und/oder UV-härtender Kleber infrage. Erfindungsgemäß kann aber abschnittsweise auch nur eine erste Dichtmasse oder eine erste Klebmasse verwendet werden.

Die Dichtmassen und/oder Klebmassen können in der E-bene der Linsenplatte bzw. der Bodenplatte parallel zueinander umlaufend angeordnet sein. Es kann aber beispielsweise auch eine oder mehrere Dichtmassen zwischen dem Rand der Linsenplatte bzw. der Bodenplatte und dem Rahmen untergebracht sein. Als Rand der Linsenplatte bzw. Bodenplatte werden hier jene Seiten der Linsen- bzw. Bodenplatte bezeichnet, die die jeweilige Platte zwischen der die Linsen bzw. die Solarzellen tragenden Fläche und der jeweils parallel dazu angeordneten anderen Seite begrenzen.

Der Rahmen des Konzentratormoduls grenzt den die Solarzellen enthaltenden Raum, im Folgenden als das Innere des Konzentratormoduls oder Innenraum bezeichnet, gegen den Außenraum ab. Dadurch können die Solarzellen dauerhaft vor Feuchtigkeit, Staub, Schmutz und anderen Umwelteinflüssen geschützt werden. Als Rahmen wird die Gesamtheit aller Komponenten bezeichnet, die Linsen- und Bodenplatte an deren Rand in oben beschriebener Weise verbinden.

Vorteilhafterweise sind die an die Linsenplätte und/oder die Bodenplatte grenzenden Flächen des Rahmens, wie zum Beispiel der Rand des Rahmens, breit genug um mindestens zwei Dichtlininen aus Dichtmassen und/oder Klebmasse aufzunehmen.

Der Rahmen kann erfindungsgemäß vollständig zwischen Linsen- und Bodenplatte untergebracht sein. Es können aber auch Teile des Rahmens oder der ganze Rahmen über Linsenplatte und/oder Bodenplatte hinausragen. Andererseits kann der Rahmen erfindungsgemäß aber auch so realisiert sein, dass er den Rand der Linsenplatte und/oder den Rand der Bodenplatte umgreift, so dass die Verbindung zwischen der entsprechenden Platte und dem Rahmen auf der zum äußeren des Moduls gewandten Seite der entsprechenden Platte zustande kommt. In diesem Fall kann zwischen dem Rand der Linsenplatte bzw. der Bodenplatte und der Innenseite des Rahmens ein Abstand entstehen, welcher erfindungsgemäß mit mindestens einer Dichtmasse ganz oder teilweise auf zumindest einem Teil der Länge des Rahmens gefüllt sein kann aber nicht muss. Insbesondere wenn der Rahmen die Platten umgreift, kann in die zum Äußeren hin orientierte Verbindungsstelle zwischen Rahmen und der jeweiligen Platte eine einzelne Dichtmasse oder eine Klebmasse untergebracht sein, während die andere Dichtmasse dann wie oben beschrieben zwischen dem Rand der Platte und dem Rahmen untergebracht ist. Auch abschnittsweise Realisierungen einer der oben genannten Bauformen des Rahmens liegen im Bereich der Erfindung.

Der Rahmen kann erfindungsgemäß ganz oder teilweise aus Hohlprofilen bestehen, welche leer oder mit Sorptionsmittel gefüllt sein können, wobei als Sorptionsmittel unter anderem SiO₂, Silika Gel, Kalziumchloris, Kalziumfluorid, Magnesiumsulfat, Natriumsulfat und/ oder kalzinierte Tonerde infrage kommt.

Diese Hohlprofile können dabei von beliebiger Form sein. Sie können beispielsweise die volle Breite des Rahmens, das heißt den gesamten Abstand zwischen Linsenplatte und Bodenplatte, ausfüllen. Sie können aber auch nur einen Teil der Breite des Rahmens ausfüllen, wobei der Rest der Breite durch Abstandsrahmen gebildet wird. Diese Abstandsrahmen sind zwischen den Hohlprofilen sowie zwischen den Hohlprofilen und der Linsenplatte bzw. der Bodenplatte so angeordnet, dass sich der Rahmen, bestehend aus einem oder mehreren Hohlprofilen und Abstandsrahmen, mindestens über den gesamten Abstand zwischen Linsenplatte und Bodenplatte erstreckt.

Der Rahmen kann aber auch nur entlang eines Teils seiner Länge aus einem oder mehreren Hohlprofilen bestehen. Unter der Länge des Rahmens werde hier wie im Folgenden seine Ausdehnung parallel zum Rand von Linsenplatte bzw. Bodenplatte verstanden.

Erfindungsgemäß ist auch ein Rahmen, der über einen Teil seiner Länge auf einem Teil seiner Breite oder auf seiner gesamten Breite ein oder mehrere Hohlprofile enthält, wobei der entstehende Rest der Breite des Rahmens durch einen oder mehrere Abstandsrahmen gebildet würde. Auf Abschnitten der Rahmenlänge, die keine Hohlprofile aufweisen, besteht der Rahmen auf seiner ganzen Breite aus einem Abstandsrahmen.

Vorteilhafterweise werden die Abstandsrahmen und/oder Hohlprofile so realisiert, dass ihre in der Ebene des Rahmens liegende Randflächen hinreichend breit sind, den mindestens zwei Dichtmassen und/oder Klebmassen Platz zu bieten um die Abdichtung des Moduls zu ermöglichen. Hier kommen alle verschiedenen Kombinationen von Dichtmassen und Klebmassen sowie auch deren einzelne Verwendung infrage. Die Dicht- bzw. Klebmassen verlaufen vorzugsweise entlang der Verbindungsstelle der Hohlprofile mit anderen Hohlprofilen, dem Rahmen, dem Abstandshalter, der Linsenplatte bzw. der Bodenplatte. Prinzipiell können alle Verbindungsstellen zwischen den einzelnen Elementen des Moduls mit Dicht- und/oder Klebmassen einzeln oder nebeneinander abgedichtet sein.

In einer weiteren vorteilhaften Ausgestaltung der Erfindung ist der Rahmen und/oder mindestens ein Hohlprofil und/oder mindestens ein Abstandsrahmen mit einer oder mehreren Öffnungen versehen. Diese Öffnungen können an der zum Innenraum des Moduls hin orientierten Seite von Hohlprofilen, im Folgenden als Innenseite bezeichnet, oder an der zum Außenraum hin orientierten Seite, im Folgenden als Außenseite bezeichnet, untergebracht sein.

Als einfache Löcher in der Innenseite dienen sie dem Abtransport von Feuchtigkeit in das Innere des Hohlprofils, wo die Feuchtigkeit durch die ein oder mehreren Sorptionsmittel absorbiert werden kann.

Die Öffnungen können an jeder der oben genannten Positionen auch dazu dienen, weitere Komponenten in das Konzentratormodul zu integrieren. Erfindungsgemäß können ein oder mehrere Filter in geeignet gestalteten Öffnungen so untergebracht werden, dass sie die jeweilige Öffnung vollständig ausfüllen und den kontrollierten Austausch von Luft oder anderen Gasen zwischen Innen- und Außenraum ermöglichen. Die Filter können dabei zum Beispiel ein Sintermetall und/oder, ein Metallgitter und/oder ein Kunststoffnetz und/oder eine Kunststoffmembran enthalten oder daraus bestehen. Besonders erwähnt sei eine Anordnung von Filtern nach vorangegangener Beschreibung, bei der ein oder mehrere Filter in der Innenseite eines Hohlprofils und ein oder mehrere Filter in der Außenseite des gleichen Hohlprofils untergebracht sind, so dass Luft oder ein anderes Gas durch die Filter und das Hohlprofil hindurch in den Innenraum des Moduls oder aus dem Modul heraus strömen kann. Auf diese Weise kann ein Druckausgleich zwischen Innen- und Außenraum erreicht werden, durch welchen das Aufwölben der Linsenplatte und/oder der Bodenplatte bei Erwärmung des Moduls verhindert wird. Dabei kann die einströmende Luft durch das Sorptionsmittel im Hohlprofil getrocknet werden, so dass Feuchtigkeitseintrag ins Konzentratormodul vermieden wird. Vorteilhafterweise werden für die äußeren Filter gröbere und für die inneren feinere Strukturen gewählt. Zum Beispiel kann der äußere Filter darauf ausgelegt sein, Teilchen größer als 50 µm auszuschließen. Der feinere, innere Filter könnte beispielsweise Teilchen bis zu einer Größe von 5 µm passieren lassen.

Der Prozess des Gasaustausches mit dem Außenraum kann durch gezielte Erwärmung von zumindest Teilen des Konzentratormoduls gesteuert werden. Die Erwärmung zum geeigneten Zeitpunkt kann erfindungsgemäß durch eine lichtabsorbierende Färbung eines Teils des Konzentratormoduls geschehen, so dass bei beginnender Sonneneinstrahlung Luft aus dem Konzentratormodul ausströmt und bei ausbleibender Sonneneinstrahlung durch das Sorptionsmittel getrocknete Luft in den Innenraum einströmt.

Erfindungsgemäß können in den Rahmen des Moduls auch ein oder mehrere Verbindungselemente integriert sein, die die mechanische Verbindung des Konzentratormoduls mit anderen Modulen ermöglicht. Dieser Verbindungselemente können auch steckbar realisiert sein und/oder in einer oder mehrerer der oben beschriebenen Öffnungen im Rahmen untergebracht sein.

Die Verbindungselemente können gasdurchlässig realisiert sein, so dass extern getrocknete Luft oder ein anderes Gas in den Innenraum des Moduls eingebracht werden kann. Es können auch mehrere Module der hier beschriebenen Art über eine solche Verbindung miteinander verbunden werden, so dass extern getrocknete Luft durch das ganze System von Konzentratormodulen geleitet werden kann.

In einer weiteren erfindungsgemäßen Ausgestaltung des Moduls ist in den Rahmen eine elektrische Durchführung, vorzugsweise feuchtigkeits- und/oder gasdicht, integriert. Eine einfache Ausführungsform ist in der Patentschrift WO 03/028114 beschrieben. Diese elektrische Durchführung kann im Inneren mit den Solarzellen zum Beispiel durch einen Draht verbunden sein und dient dann der elektrischen Verschaltung der Solarzellen mit Vorrichtungen im Außenraum.

Der Rahmen kann darüber hinaus der Befestigung von Vorrichtungen dienen, welche den Betrieb des Solarzellenmoduls als einzelnes oder im Verbund mit anderen Modulen unterstützt. So kann zum Beispiel eine Halterung am Rahmen angeschweißt oder angeschraubt werden, mit welcher sich das Solarzellenmodul zum Beispiel auf einer Nachführeinheit montieren und/oder justieren lässt. Die Halterung kann eine Schraubverbindung aufweisen. Sie kann aber auch derart gestaltet sein, dass sie die schnelle Verbindung von Modulen zum Beispiel durch Einhängen erlaubt. Die Halterung kann zudem elektrisch leitende Komponenten enthalten, so dass sie die Erdung des Konzentratormoduls ermöglicht.

Als Material für den Rahmen, die Hohlprofile und die Abstandsrahmen eignen sich Stahl, verzinkter Stahl, Edelstahl, Aluminium und/oder andere Metalle sowie Verbundstoffe, Plexiglas, Polymethylmethacrylat (PMMA), Acrylglas, andere Kunststoffe und Glas. Die Materialien können alleine oder in Kombination verwendet werden.

In einer vorteilhaften Ausgestaltung der Erfindung weist der Innenraum des Konzentratormoduls Abstandshalter auf, welche die Linsenplatte und die Bodenplatte miteinander verbinden. Diese Abstandshalter können beliebige Formen haben. Beispielsweise können die Abstandshalter zwischen Linsen- und Bodenplatte gebrachte Zylinder oder Quader sein. Besonders vorteilhaft ist jedoch eine Form (Doppel-T-Form genannt) die im Querschnitt zwei parallele Abschnitte aufweist, welche in ihrer Mitte über einen dritten Abschnitt miteinander verbunden sind. Die beiden parallelen Abschnitte grenzen dabei an die Linsen- bzw. Bodenplatte.

In einer weiteren Ausgestaltung des erfindungsgemäßen Moduls können die Linsenplatte und/oder die Bodenplatte aus mehreren benachbarten Teilplatten bestehen, welche in einer Ebene liegen. Dies ermöglicht die Herstellung von großen Modulen mit einer Vielzahl von Linsen- und Bodenplatten, deren Größe die technische realisierbare Größe einer einzelnen Linsen- oder Bodenplatte überschreitet. Zwischen den Rändern der Teilplatten kann dabei ein Grenzbereich entstehen, der sich in Richtung der Ränder der jeweiligen Teilflächen ausdehnt. Da dieser Grenzbereich einen Abstand zwischen den Teilplatten darstellt, kann er dazu dienen, mechanische Belastungen auf die jeweilige Platte aufzunehmen. Hierzu ist er vorteilhafterweise mit einer Dichtmasse, zum Beispiel elastisches Silikon enthaltend oder daraus bestehend, gefüllt. Sinnvollerweise sind unter zumindest einem Teil der entstehenden Grenzbereiche zwischen Teilplatten zumindest über einen Teil ihrer Länge Abstandshalter zwischen Linsen- und Bodenplatte angebracht. Dabei können die Abstandshalter in ihrem Querschnitt senkrecht zur Längsausdehnung des Grenzbereiches oben beschriebene Doppel-T-Form aufweisen, so dass der Abstandshalter an sich relativ schmal ist, aber dem Grenzbereich eine breite Fläche entgegenbringt. Auf dieser relativ breiten Fläche kann zwischen dem Abstandshalter und der Linsen- bzw. Bodenplatte mindestens eine Dichtmasse und/oder Klebmasse entlang jeder Seite des Grenzbereiches untergebracht sein, so dass der Innenraum des Moduls gegen den Außenraum abgedichtet ist.

Im erfindungsgemäßen Verfahren zur Herstellung des photovoltaischen Konzentratormoduls werden Linsenplatte und Bodenplatte derart miteinander verpresst, dass der Abstand zwischen der Linsenplatte und der Bodenplatte mit einer Toleranz < 1 mm, vorzugsweise < 500 µm, eingehalten wird. Hierzu kann zwischen Linsenplatte und Bodenplatte ein Abstandshalter platziert werden. Linsenplatte und Bodenplatte werden dann gegen den Rahmen des Konzentratormoduls gedrückt, bis sie den Abstandshalter berühren. Es ist außerdem auch möglich, den Abstand zwischen Linsenplatte und Bodenplatte während des Vorgangs des Verpressens von Linsenplatte und Bodenplatte mit dem Rahmen durch die Elastizität der Butylschnur oder der entsprechenden Klebmasse zu begrenzen. Hierbei werden Linsenplatte und Bodenplatte mit einer Kraft gegen den Rahmen gedrückt, bis die von der Butylschnur auf Linsenplatte und Bodenplatte ausgeübte Kraft gleich der Andruckkraft ist.

Das Anpressen kann durch Kraftausübung von außen geschehen, es ist aber auch möglich, die Linsenplatte und die Bodenplatte dadurch gegen den Rahmen zu drücken, dass im Innenraum des Konzentratormoduls, d.h. in dem vom Rahmen umgebenen Bereich zwischen Linsenplatte und Bodenplatte, ein Vakuum erzeugt wird. Linsenplatte und Bodenplatte werden dann also gegen den Rahmen gesaugt.

Die beschriebene Erfindung weist folgende Vorteile gegenüber dem Stand der Technik auf:
- Die beanspruchte Erfindung macht es möglich, den Abstand zwischen Linsenplatte und Bodenplatte exakt festzulegen, so dass eine bestmögliche Ausleuchtung der Solarzellenfläche erreicht wird.
- Das beanspruchte photovoltaische Konzentratormodul kann kostengünstig und flexibel hergestellt werden. Im Gegensatz zu den aus dem Stand der Technik bekannten Glasrahmen oder verschraubten Metallprofilen kann der Rahmen eventuellen Bedürfnissen ohne weiteres angepasst werden.
- Das Modul ist luft- und/oder feuchtigkeitsdicht und behält diese Eigenschaft über einen deutlich längeren Zeitraum als nach dem Stand der Technik bekannte Konzentratormodule.
- Der Rahmen des Konzentratormoduls kann ganz oder teilweise aus Hohlprofilen bestehen, welche Sorptionsmittel aufnehmen können, wodurch sich im Modul befindende Luft und in das Modul einfließende Luft getrocknet werden kann.
- Öffnungen können ohne großen Aufwand und mit beliebigen Formen im Rahmen des Moduls untergebracht werden. Die Öffnungen können zum Beispiel Filter aufnehmen.
- Das beanspruchte Konzentratormodul kann dadurch kontrolliert belüftet werden. Es kann getrocknete Luft in das Innere geleitet werden oder feuchte Luft aus dem inneren abgesaugt werden.
- Das beanspruchte Konzentratormodul erlaubt es, elektrische Durchführungen zwischen der Innenseite des Konzentratormoduls und der Außenseite luft- und/oder feuchtigkeitsdicht in den Rahmen zu integrieren.
- Eine große Zahl der beanspruchten Konzentratormodule kann über Verbindungseinheiten miteinander verbunden werden, so dass zum Beispiel mehrere Konzentratormodule zusammen mit extern getrockneter Luft versorgt werden können.

Im Folgenden werden nun einige Beispiele erfindungsgemäßer Konzentratormodule gegeben. Dabei werden für gleiche und ähnliche Elemente gleiche und ähnliche Bezugszeichen verwendet.
- Figur 1: zeigt den Teil eines Schnittes durch ein erfindungsgemäßes Konzentratormodul.
- Figur 2: zeigt den Teil eines Schnittes durch ein erfindungsgemäßes Konzentratormodul, mit einem Rahmen, der auf voller Breite aus einem mit Sorptionsmittel gefüllten Hohlprofil besteht.
- Figur 3: zeigt den Teil eines Schnittes durch ein erfindungsgemäßes Konzentratormodul, mit einem Rahmen, der zwei durch einen Abstandsrahmen getrennte Hohlprofile enthält.
- Figur 4: zeigt den Teil eines Schnittes durch ein erfindungsgemäßes Konzentratormodul wie Figur 2, wobei in das Hohlprofil Filter integriert sind.
- Figur 5: zeigt den Teil eines Schnittes durch ein erfindungsgemäßes Konzentratormodul, mit einem Rahmen, an den eine Halterung angebracht ist und in den ein Filter und eine elektrische Durchführung integriert sind.
- Figur 6: zeigt den Teil eines Schnittes durch ein erfindungsgemäßes Konzentratormodul mit einem Rahmen, in den eine elektrische Durchführung integriert ist.
- Figur 7: zeigt einen Teil einer Seitenansicht eines erfindungsgemäßen Konzentratormoduls mit einer Kabeldurchführung mit ovalem Rand.
- Figur 8: zeigt den Teil eines Schnittes durch ein erfindungsgemäßes Konzentratormodul, dessen Rahmen mehrere Hohlprofile sowie eine elektrische Durchführung enthält.
- Figur 9: zeigt den Teil eines Schnittes durch ein erfindungsgemäßes Konzentratormodul, in dessen Rahmen eine Halterung zum Aufhängen des Moduls integriert ist.
- Figur 10: zeigt den Teil eines Schnittes durch zwei erfindungsgemäße Konzentratormodule, welche über eine Verbindungseinheit miteinander verbunden sind.
- Figur 11: zeigt die Aufsicht auf ein erfindungsgemäßes Konzentratormodul, dessen Linsenplatte und/oder Bodenplatte aus mehreren Teilplatten besteht.
- Figur 12: zeigt einen Abstandhalter zwischen einem Stück der Linsenplatte und einem Stück der Bodenplatte.

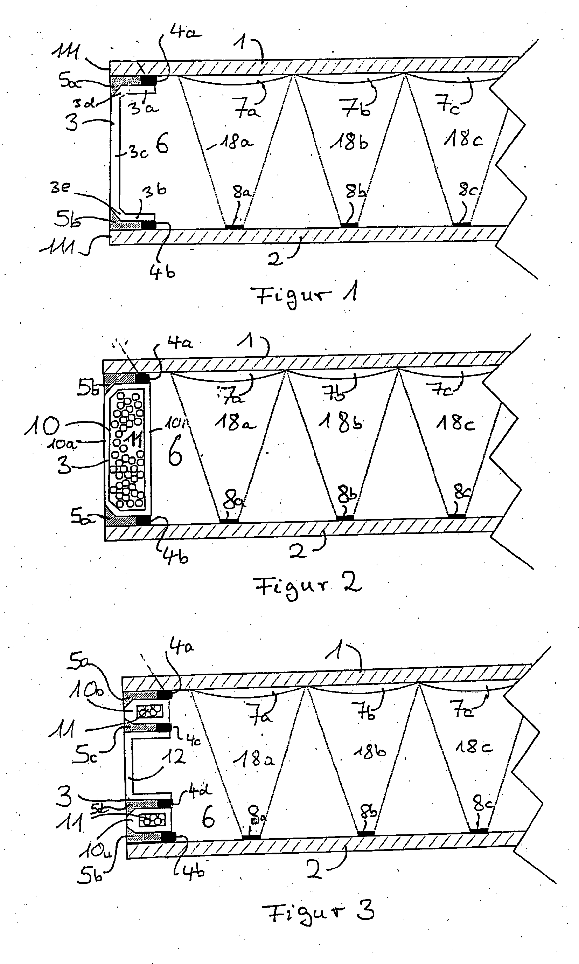

Figur 1 zeigt den Teil eines Schnittes durch ein Konzentratormodul gemäß der vorliegenden Erfindung. Eine die fokussierenden Linsen 7a, 7b und 7c tragende, zur optischen Ebene der Linsen 7a, 7b und 7c parallele, transparente Linsenplatte 1 liegt parallel zu einer, die Solarzellen 8a, 8b und 8c tragenden Bodenplatte 2. Zwischen der Linsenplatte 1 und der Bodenplatte 2 ist entlang des Randes von Linsenplatte 1 und Bodenplatte 2 ein Rahmen 3 angeordnet, der den gesamten Abstand zwischen der Linsenplatte 1 und der Bodenplatte 2 überdeckt. Im gezeigten Beispiel beschreibt der Querschnitt des Rahmens 3 eine U-Form, wobei jeweils ein kurzer Schenkel 3a und 3b zur Linsenplatte 1 bzw. Bodenplatte hin orientiert ist und eine lange Seite 3c sich zwischen Linsenplatte 1 und Bodenplatte 2 erstreckt. Die Ecken des Rahmens 3d und 3e sind im gezeigten Beispiel über ein kurzes Stück angeschrägt, so dass die lange Seite 3c des Rahmens 3 nicht dem gesamten Abstand zwischen Linsenplatte 1 und Bodenplatte 2 überspannt sondern einen kleinen Raum für je eine äußere Dichtmasse 5a und 5b lässt.

Die Kontaktstellen zwischen der Linsenplatte 1 und dem Rahmen 3 sowie zwischen der Bodenplatte 2 und dem Rahmen 3 sind durch je zwei Dichtmassen 4a und 4b sowie 5a und 5b abgedichtet. Die Dichtmassen 4a und 4b können erfindungsgemäß auch durch Klebmassen 4a und 4b ersetzt werden.

Die Dicht- bzw. Klebmassen 4a und 4b sowie die Dichtmassen 5a und 5b sind zwischen dem der Linsenplatte 1 zugewandten Rand 3a des Rahmens 3 und der Linsenplatte 1 sowie zwischen dem der Bodenplatte 2 zugewandten Rand 3b des Rahmens 3 und der Bodenplatte 2 in der Ebene der Linsenplatte 1 bzw. der Bodenplatte 2 parallel zueinander angeordnet und laufen parallel zum Rahmen 3 über seine gesamte Länge. Als äußere Dichtmassen 5a und 5b kann zum Beispiel elastisches Silikon verwendet werden, als innere Dichtmassen 4a und 4b eignen sich beispielsweise Butylschnüre. Befinden sich an der Stelle der Dichtmassen 4a und 4b Klebmassen 4a und 4b zwischen dem Rahmen und er entsprechenden Platte, so eignet sich hier zum Beispiel Heißkleber oder UV-härtender Klebstoff.

Im hier gezeigten Beispiel erstrecken sich die Dichtmassen bzw. Klebmassen 4a und 4b sowie die Dichtmassen 5a und 5b über die gesamte Tiefe des Rahmens 3, das heißt seine gesamte Ausdehnung in Richtung des Innenraums 6 des Moduls. Dabei liegen die Dicht- bzw. Klebmassen 4a und 4b zum Innenraum 6 hin, während die Dichtmassen 5a und 5b nach außen hin den restlichen, von den inneren Dicht- bzw. Klebmassen 4a und 4b nicht erfüllten, Raum zwischen dem Rahmen 3 und der Linsenplatte 1 bzw. der Bodenplatte 2 ausfüllen.

Die Solarzellen 8a, 8b und 8c befinden sich im Fokus der Linsen 7a, 7b bzw. 7c, welche auf der Linsenplatte 1 derart nebeneinander angeordnet sind, dass sie die Fläche der Linsenplatte 1 vorzugsweise möglichst vollständig überdecken. Zum Beispiel können die Linsen 7a, 7b und 7c rechteckig und von gleicher Fläche sein, so dass sie dergestalt nebeneinander angeordnet werden können, dass die Fläche der Linsenplatte lückenlos überdeckt wird. Jede Linse 7a, 7b und 7c bündelt das Licht 18a, 18b bzw. 18c auf je eine Solarzelle 8a, 8b bzw. 8c.

Figur 2 zeigt den Teil eines Schnittes durch ein Konzentratormodul analog zu Figur 1 mit dem Unterschied, dass hier der Rahmen 3 auf seiner ganzen Breite aus einem Hohlprofil 10 besteht, welches mit einem oder mehreren Sorptionsmitteln 11 gefüllt ist. Das Hohlprofil 10 kann, solange es die beschriebenen Anforderungen erfüllt, von beliebiger Form sein. Das in Figur 2 gezeigte Hohlprofil 10 weist beispielsweise einen rechteckigen Querschnitt auf, wobei die beiden zum Außenraum liegenden Ecken des Querschnitts angeschrägt sind, so dass sowohl die nach innen 10i wie die nach außen gerichtete Seite 10a des Hohlprofils 10 senkrecht auf Linsenplatte 1 und Bodenplatte 2 stehen, aber die Außenseite 10a des Hohlprofils 10 etwas kürzer ist als die.Innenseite 10i. Die in Richtung der Linsenplatte 1 und der Bodenplatte 2 orientierten Seiten des Hohlprofils 10 sind in diesem Beispiel auf einem Teil ihrer Länge parallel zur Linsenplatte 1 bzw. Bodenplatte 2 und über den Rest des Abstandes zwischen Innenseite 10i und Außenseite 10a des Hohlprofils 10 abgeschrägt.

Die Verbindungsstellen des Hohlprofils 10 zu der Linsenplatte 1 und der Bodenplatte 2 sind jeweils, wie in Figur 1, mit zwei entlang der Länge des Rahmens umlaufenden Dicht- oder Klebmassen 4a und 4b sowie Dichtmassen 5a und 5b abgedichtet. Im hier gezeigten Beispiel erstrecken sich die Dicht- bzw. Klebmassen 4a und 4b sowie 5a und 5b über die gesamte Tiefe des Hohlprofils 10, das heißt seine gesamte Ausdehnung in Richtung des Innenraums 6 des Moduls. Dabei liegen die Dicht- bzw. Klebmassen 4a und 4b, zum Beispiel Butylschnüre für den Fall von Dichtmassen oder Heißkleber oder UV-Kleber für den Fall von Klebmassen, zum Innenraum 6 hin, während die Dichtmassen 5a und 5b, zum Beispiel elastisches Silikon, den restlichen, von den Butylschnüren oder den Klebmassen nicht erfüllten, Raum zwischen dem Hohlprofil 10 und der Linsenplatte 1 bzw. der Bodenplatte 2 ausfüllen.

Figur 3 zeigt den Teil eines Schnittes durch ein Konzentratormodul, dessen Rahmen 3 zwei mit Sorptionsmitteln 11 gefüllte Hohlprofile 10) und 10u aufweist, von denen eines 10o an die Linsenplatte 1 angrenzt und eines 10u an die Bodenplatte 2 angrenzt, und zwischen denen ein Abstandsrahmen 12 den Rahmen 3 auf seiner verbleibenden Breite aufbaut. Dabei sind die Verbindungsstellen zwischen den Hohlprofilen 10o und 10u und dem Abstandsrahmen 12 sowie zwischen den Hohlprofilen 10o und 10u sowie der Linsenplatte 1 bzw. der Bodenplatte 2 durch je zwei Dichtmassen 4a und 4b oder Klebmassen 4a und 4b sowie Dichtmassen 5a und 5b abgedichtet, welche parallel zur Länge des Rahmens 3 als zwei Dichtlinien umlaufen. Im gezeigten Beispiel hat der Querschnitt der Hohlprofile 100 und 10u die für die vorhergehenden Figuren beschriebene Form, allerdings ist die nach innen gerichtete und die nach außen gerichtete Seite deutlich kürzer. Der Querschnitt des Abstandsrahmens 12 hat im gezeigten Beispiel eine U-Form, wobei die zwei Schenkel des U nach innen gerichtet sind. Die anderen gezeigten Elemente entsprechen jenen der vorhergehenden Figuren.

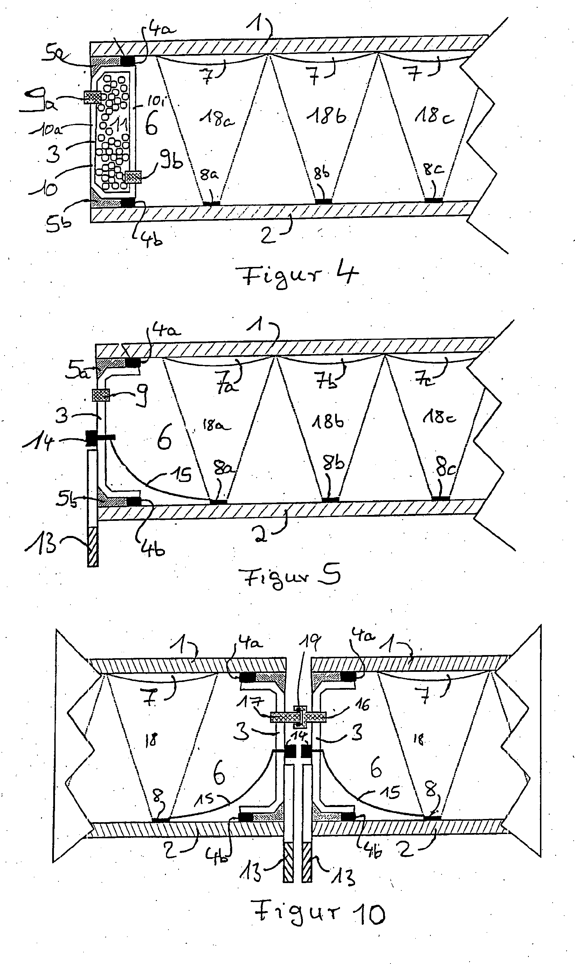

Figur 4 zeigt den Teil eines Schnittes durch ein Konzentratormodul, dessen Rahmen 3 auf voller Breite aus einem mit Sorptionsmittel 11 gefüllten Hohlprofil 10 besteht, in dessen Außenseite 10a und Innenseite 10i je ein Filter 9a bzw. 9b integriert ist, so dass Luft an dem Sorptionsmittel 11 vorbei in das Innere 6 des Konzentratormoduls oder aus dem Konzentratormodul hinaus strömen kann. Einer der Filter 9a befindet sich in dieser Figur näher an der Linsenplatte 1, während der andere Filter 9b näher an der Bodenplatte 2 liegt, so dass das Gas, welches durch das Hohlprofil 10 strömt, im Sorptionsmittel 11 einen möglichst weiten Weg zurücklegt. Die Filter 9a und 9b können darüber hinaus auch entlang der Länge des Rahmens 3 versetzt angeordnet sein, so dass der Weg des Gases durch das Sorptionsmittel 11 weiter verlängert wird. Die anderen gezeigten Elemente entsprechen jenen der vorhergehenden Figuren.

Figur 5 zeigt einen Ausschnitt aus einem Konzentratormodul, an dessen Rahmen 3 eine Halterung 13, zum Beispiel zur Montage des Konzentratormoduls an einer Nachführeinheit, befestigt ist. Die Halterung 13 kann zum Beispiel eine angeschweißte Schraubverbindung sein. Darüber hinaus weist der hier abgebildete Rahmen 3 eine Öffnung in der Breitseite auf, welche von einem Filter 9 vollständig ausgefüllt wird. Als Breitseite des Rahmens sei jene Seite des Rahmens bezeichnet, die senkrecht zur Ebene der Linsenplatte 1 und der Bodenplatte 2 steht. Durch den Filter 9 kann Gas direkt vom Außenraum in das Innere 6 des Konzentratormoduls geleitet werden oder strömen, ohne ein Sorptionsmittel 11 zu passieren.

Figur 5 zeigt außerdem eine, in der Breitseite des Rahmens untergebrachte, elektrische Durchführung 14 zwischen dem Innenraum 6 des Moduls und dem Außenraum, welche über eine elektrische Verbindung 15 mit den auf der Bodenplatte 2 verschalteten Solarzellen 8a, 8b und 8c verbunden ist. Diese Durchführung 14 kann zum Beispiel wie in WO 03/028114 beschrieben ausgeführt sein. Die anderen gezeigten Elemente entsprechen denen der vorhergehenden Figuren.

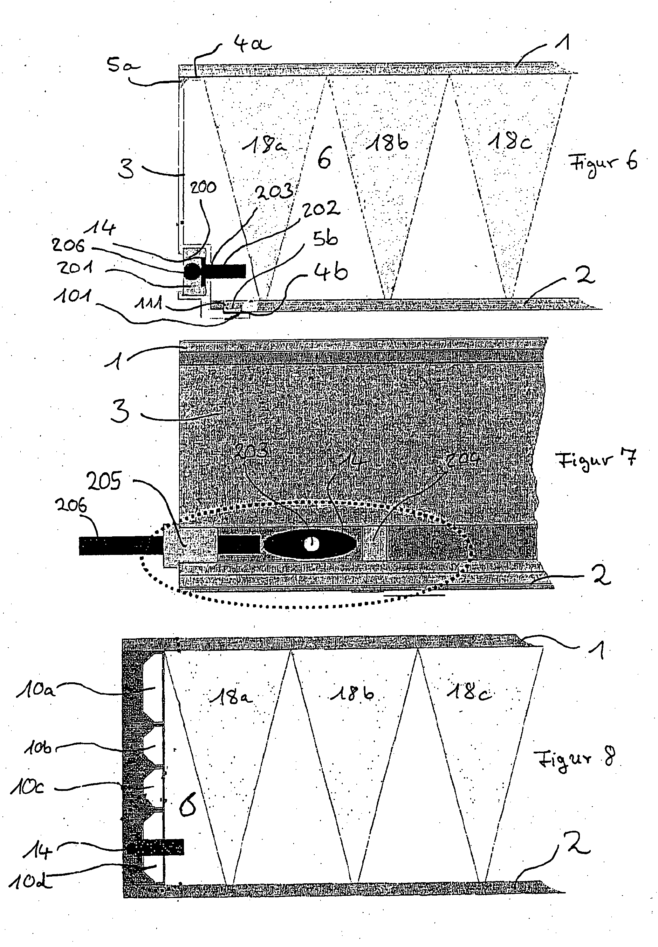

Figur 6 zeigt den Teil eines Schnittes durch ein erfindungsgemäßes Konzentratormodul, in dessen Rahmen eine elektrische Durchführung 14 eingebaut ist. Die elektrische Durchführung 14 ist hier in eine Einbuchtung 200 im Rahmen 3 eingebaut. Der nicht von der Durchführung 14 ausgefüllte Raum der Einbuchtung 200 ist hier mit einer Dichtmasse 201, zum Beispiel Silikon, gefüllt, so dass die Verbindungsstellen zwischen Rahmen 3 und Durchführung 14 abgedichtet sind. Die Durchführung 14 weist darüber hinaus eine Kunststoffhülse 202 auf, die in das Innere des Moduls 6 hineinragt. Eine solche Durchführung 14 zeichnet sich durch einfache, schnelle Montage sowie geringe Kosten aus und kann gleichzeitig zur Zugentlastung dienen. Darüber hinaus ist in Figur 6 der Rahmen 3 nicht vollständig zwischen der Linsenplatte 1 und der Bodenplatte 2 untergebracht sondern umgreift die Bodenplatte 2, so dass diese auf einem Teil 101 des Rahmens 3 aufliegt. Zwischen der Bodenplatte 2 und dem Rahmen 3 ist entlang der Auflagefläche eine Dichtmasse 4b zur Abdichtung des Moduls untergebracht. Außerdem zeigt die Figur 6 zwischen dem Rand der Bodenplatte 111 und dem Rahmen 3 eine Dichtmasse 5b. Die anderen gezeigten Komponenten entsprechen denen der vorhergehenden Figuren.

Figur 7 zeigt einen Teil der Seitenansicht eines erfindungsgemäßen Konzentratormoduls mit Blick auf die Fläche des Rahmens 3. Die Kabeldurchführung 14 ist hier in Richtung ihres Durchführungskanals 203 zu sehen, welcher durch die in Fig. 6 gezeigte Kunstoffhülse verläuft. Neben der Durchführung 14 ist rechts ein Schiebeklotz ohne Lochbohrung 204 und links ein Schiebeklotz mit Lochbohrung 205 angeordnet. Der Schiebeklotz mit Lochbohrung 205 wird über ein Anschlusskabel 206 zum Anschließen des Solarmoduls geschoben und dient dann der Führung und/oder Zugentlastung des Kabels 206. Die beiden Schiebeklötze 204 und 205 werden in die Ausbuchtung 200 des Rahmens 3 geschoben, so dass der die Durchführung 14 umgebenden Bereich der Ausbuchtung 200 mit Dichtmasse 201 gefüllt werden kann, ohne in andere Bereiche der Ausbuchtung 200 zu laufen.

Figur 8 zeigt den Teil eines Schnittes durch ein erfindungsgemäßes Konzentratormodul, dessen Rahmen 3 mehrere Hohlprofile 10a, 10b, 10c, und 10d enthält. Dabei sind die Hohlprofile 10a, 10b, 10c und 10d so nebeneinander angeordnet, dass sie den Rahmen 3 auf dem gesamten Abstand zwischen Linsenplatte 1 und Bodenplatte 2 bilden. Darüber hinaus zeigt Figur 8 eine elektrische Durchführung 14 durch ein Hohlprofil 10d. Sie ist hier als Kanal mit einer Kunststoffhülse 202 ausgebildet, welcher durch das Hohlprofil 10d derart hindurchführt, dass das Innere des Hohlprofils 10d weder zum Außenraum noch zum Innenraum 6 hin geöffnet wird, aber eine Verbindung zwischen Innenraum 6 und Außenraum entsteht. Die anderen gezeigten Komponenten entsprechen denen der vorhergehenden Figuren.

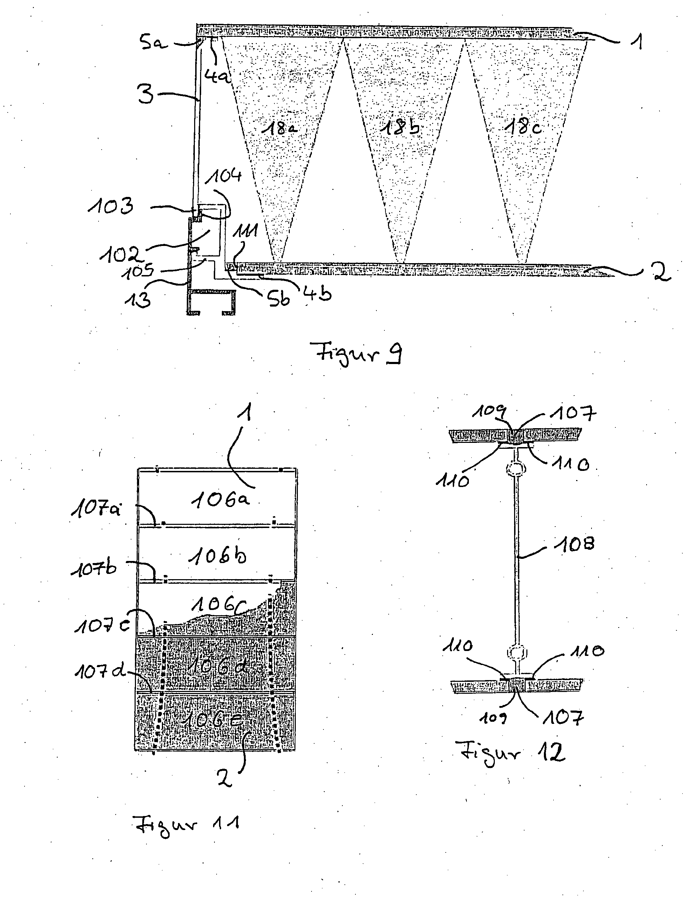

Figur 9 zeigt den Teil eines Schnittes durch ein erfindungsgemäßes Konzentratormodul, in dessen Rahmen 3 eine Halterung 13 integriert ist. Hierbei sitzt das Halteelement 13 derart in einer Ausbuchtung 102 mit viereckigem Querschnitt des Rahmens 3, dass das Konzentratormodul auf die Halterung 13 gehängt werden kann. Hierzu weist die Ausbuchtung 102 an der zur Linsenplatte 1 nach außen gewandten Kante einen Überstand 103 in der Ebene der Rahmenaußenseite auf, der gegen eine Ecke 104 in der Halterung 13 drückt welche in die Ausbuchtung 102 hineingreift, während gleichzeitig die zur Bodenplatte hin nach außen gewandte Kante 105 der Ausbuchtung 102 durch das Gewicht des Konzentratormodules gegen die Halterung 13 drückt. Die anderen gezeigten Komponenten entsprechen jenen in den vorhergehenden Figuren.

Figur 10 zeigt Teile eines Schnittes durch zwei Konzentratormodule, welche über ein Verbinungselement miteinander verbunden sind. Das Verbindungselement ist eine Steckverbindung aus einem Stecker 17 und einer Buchse 16. Stecker 17 und Buchse 16 können in das entsprechende Modul eingesteckt sein, an es angeschweißt oder anders mit ihm verbunden sein. Der Stecker 17 des einen Moduls ist in die Buchse 16 des anderen Moduls eingesteckt und die Kontaktstelle zwischen Stecker 17 und Buchse 16 durch eine an der Kontaktstelle in der Ebene senkrecht zur Verbindungsachse entlanglaufende Dichtmasse 19 abgedichtet. Die Steckverbindung aus Stecker 17 und Buchse 16 kann erfindungsgemäß gasdurchlässig sein, so dass Gas von einem Modul in das andere geleitet werden kann. Jedes Modul kann mehrere Stecker 17 und/oder Buchsen 16 aufweisen, über welche es mit mehreren anderen Modulen verbunden werden kann, so dass zum Beispiel extern getrocknete Luft aktiv durch mehrere Konzentratormodule geleitet werden kann. Die anderen gezeigten Elemente entsprechen denen der vorhergehenden.Figuren.

Figur 11 zeigt die Aufsicht auf ein erfindungsgemäßes Konzentratormodul, dessen Linsenplatte 1 und/oder Bodenplatte 2 aus mehreren Teilplatten 106a bis 106e besteht. Die Teilplatten sind hier rechteckig ausgeführt und sind entlang ihrer Längsseite parallel nebeneinander angeordnet. Aber auch andere Formen sind möglich. Zwischen den Teilplatten 106a bis 106e ergeben sich Grenzbereiche 107a bis 107d.

Figur 12 schließlich zeigt einen Abstandshalter 108, wie er im Inneren 6 des Konzentratormoduls zwischen Linsenplatte 1 und Bodenplatte 2 angebracht werden kann. Die Abbildung zeigt nicht die Längsausdehnung des Abstandhalters 108. Vorzugsweise folgt sie dem Längsverlauf des Grenzbereiches 107. Ein Abstandshalter 108 wie gezeigt kann unter jedem Grenzbereich 107 entlang dessen ganzer Länge oder entlang eines Teils seiner Länge angeordnet sein. In Abbildung 12, ist darüber hinaus zu erkennen, wie eine erste Dichtmasse 109 den Grenzbereich 107 ausfüllt und zwei zweite Dichtmassen oder Klebemassen 110 entlang der Berührungsfläche von Linsenplatte 1 und Abstandshalter 108 sowie von Bodenplatte 2 und Abstandshalter 108 auf beiden Seiten des Grenzbereichs 107 parallel zu dessen Länge verlaufen.

## Patentansprüche

1. Photovoltaisches Konzentratormodul mit
einer Linsenplatte (1), einer Bodenplatte (2), auf welcher Solarzellen (8) untergebracht sind und einem Rahmen (3), welcher, die Linsenplatte (1) und die Bodenplatte (2) verbindend, längs des Randes (111) der Linsenplatte (1) und der Bodenplatte (2) umlaufend angeordnet ist,
**dadurch gekennzeichnet,**
**dass** entlang des Rahmens (3) zwischen der Linsenplatte (1) und dem Rahmen (3) und/oder der Bodenplatte (2) und dem Rahmen (3) zum einen mindestens eine erste Dichtmasse (4) und/oder Klebmasse (4) und zum anderen mindestens eine zweite Dichtmasse (5) zumindest auf einem Teil der Länge des Rahmens (3) umlaufend angeordnet ist,
wobei die beiden Dicht- und/oder Klebemassen sich bezüglich ihrer Aushärtezeiten und/oder Gasdurchlässigkeiten unterscheiden und zumindest eine der mindestens einen ersten Dichtmassen (4) und/oder mindestens eine der mindestens einen zweiten Dichtmassen (5) Butylschnur und/oder elastisches Silikon aufweist oder daraus besteht.

2. Photovoltaisches Konzentratormodul nach dem vorhergehenden Anspruch,
**dadurch gekennzeichnet,**
**dass** der Rahmen (3) zwischen der Linsenplatte (1) und der Bodenplatte (2) angeordnet ist.

3. Photovoltaisches Konzentratormodul nach Anspruch 1,
**dadurch gekennzeichnet,**
**dass** der Rahmen (3) den Rand (111) der Linsenplatte (1) und/oder der Bodenplatte (2) umgreift.

4. Photovoltaisches Konzentratormodul nach einem der vorhergehenden Ansprüche,
**dadurch gekennzeichnet,**
**dass** die mindestens eine erste Dichtmasse (4) und/oder Klebmasse (4) und die mindestens eine zweite Dichtmasse (5) zur Ebene der Linsenplatte (1) bzw. zur Ebene der Bodenplatte (2) und zueinander parallel entlang des Rahmens umlaufend angeordnet sind.

5. Photovoltaisches Konzentratormodul nach einem der vorhergehenden Ansprüche,
**dadurch gekennzeichnet,**
**dass** der Rahmen (3) mindestens ein Hohlprofil (10) aufweist oder daraus besteht.

6. Photovoltaisches Konzentratormodul nach Anspruch 5,
**dadurch gekennzeichnet,**
**dass** zumindest eines der mindestens einen Hohlprofile (10) Löcher zum Innenraum (6) des Moduls aufweist.

7. Photovoltaisches Konzentratormodul nach einem der Ansprüche 5 und 6,
**dadurch gekennzeichnet,**
**dass** der Rahmen (3) mindestens ein, entlang des Rahmens (3) zumindest teilweise umlaufendes, Hohlprofil (10) und mindestens einen entlang des Hohlprofils, parallel zu dem Hohlprofil umlaufenden, sich über den von dem mindestens einen Hohlprofil nicht ausgefüllten Bereich des Rahmens erstreckenden, Abstandsrahmen (12) aufweist.

8. Photovoltaisches Konzentratormodul nach einem der Ansprüche 5 bis 7,
**dadurch gekennzeichnet,**
**dass** der Rahmen (3) mindestens zwei, entlang des Rahmens (3) zumindest teilweise umlaufende, Hohlprofile (10) und mindestens einen entlang des Hohlprofils, parallel zu den Hohlprofilen umlaufenden, sich über den von den mindestens zwei Hohlprofilen nicht ausgefüllten Bereich des Rahmens erstreckenden, Abstandsrahmen (12) aufweist.

9. Photovoltaisches Konzentratormodul nach einem der Ansprüche 5 bis 8
**dadurch gekennzeichnet,**
**dass** der Rahmen (3)
oder gegebenenfalls die Wand mindestens eines der mindestens einen Hohlprofile (10) und/oder gegebenenfalls mindestens eines der mindestens einen Abstandsrahmen (12) zumindest eine Öffnung mit zumindest einem Filter (9) aufweist.

10. Photovoltaisches Konzentratormodul nach einem der vorhergehenden Ansprüche,
**dadurch gekennzeichnet,**
**dass** der Rahmen (3) eine Halterung (13) aufweist.

11. Photovoltaisches Konzentratormodul nach dem vorhergehenden Anspruch,
**dadurch gekennzeichnet,**
**dass** die Halterung (13) geeignet ist, das photovoltaische Konzentratormodul auf einer Nachführeinheit zu montieren und zu justieren.

12. Photovoltaisches Konzentratormodul nach einem der vorhergehenden Ansprüche,
**dadurch gekennzeichnet,**
**dass** der Rahmen (3) mindestens eine elektrische Verbindung (14) zwischen dem Innenraum (6) des photovoltaischen Konzentratormoduls und dem Außenraum aufweist.

13. Photovoltaisches Konzentratormodul nach dem vorhergehenden Anspruch,
**dadurch gekennzeichnet,**
**dass** die mindestens eine elektrische Verbindung (14) zwischen dem Innenraum (6) des photovoltaischen Konzentratormoduls und dem Außenraum feuchtigkeitsdicht und/oder gasdicht ist.

14. Verfahren zur Herstellung eines photovoltaischen Konzentratormoduls nach einem der vorhergehenden Ansprüche,
**dadurch gekennzeichnet,**
**dass** ein Rahmen (3), eine Linsenplatte (1) und eine Bodenplatte (2) verbindend, längs dem Rand der Linsenplatte (1) und der Bodenplatte (2) angeordnet wird, und dass zwischen den Rahmen (3) und die Linsenplatte (1) und/oder den Rahmen (3) und die Bodenplatte (2) zum einen mindestens eine erste Dichtmasse (4) und/oder Klebmasse (4) und zum anderen mindestens eine zweite Dichtmasse (5) entlang des Rahmens (3) über zumindest einen Teil seiner Länge umlaufend, eingebracht wird,
wobei die beiden Dicht- und/oder Klebemassen sich bezüglich ihrer Aushärtezeiten und/oder Gasdurchlässigkeiten unterscheiden und zumindest eine der mindestens einen ersten Dichtmassen (4) und/oder mindestens eine der mindestens einen zweiten Dichtmassen (5) Butylschnur und/oder elastisches Silikon aufweist oder daraus besteht.

## Claims

1. A photovoltaic concentrator module
having
a lens plate (1), a base plate (2) on which solar cells (8) are accommodated, and a frame (3) which is arranged to run peripherally along the edge (111) of the lens plate (1) and the base plate (2) in such a way as to connect the lens plate (1) and the base plate (2),
**characterised in that**
there are arranged to run peripherally along the frame (3), at least over part of the length of the frame (3), between the lens plate (1) and the frame (3) and/or the base plate (2) and the frame (3), on the one hand at least one first sealing compound (4) and/or adhesive compound (4) and on the other at least one second sealing compound (5),
wherein the two sealing and/or adhesive compounds differ in respect of their curing times and/or gas permeability, and at least one of the at least one first sealing compounds (4) and/or at least one of the at least one second sealing compounds (5) includes or comprises butyl cord and/or elastic silicone.

2. A photovoltaic concentrator module according to the preceding claim, **characterised in that** the frame (3) is arranged between the lens plate (1) and the base plate (2).

3. A photovoltaic concentrator module according Claim 1, **characterised in that** the frame (3) surrounds the edge (111) of the lens plate (1) and/or the base plate (2).

4. A photovoltaic concentrator module according to one of the preceding claims, **characterised in that** the at least one first sealing compound (4) and/or adhesive compound (4) and the at least one second sealing compound (5) are arranged to run peripherally along the frame, parallel to the plane of the lens plate (1) or to the plane of the base plate (2) and to one another.

5. A photovoltaic concentrator module according to one of the preceding claims, **characterised in that** the frame (3) includes or comprises at least one hollow profile (10).

6. A photovoltaic concentrator module according to Claim 5, **characterised in that** at least one of the at least one hollow profiles (10) has holes to the interior (6) of the module.

7. A photovoltaic concentrator module according to one of Claims 5 and 6, **characterised in that** the frame (3) includes at least one hollow profile (10) that runs at least partly peripherally along the frame (3) and at least one spacer frame (12) that runs peripherally along the hollow profile, parallel to the hollow profile, and extends over the region of the frame that is not filled with the at least one hollow profile.

8. A photovoltaic concentrator module according to one of Claims 5 to 7, **characterised in that** the frame (3) includes at least two hollow profiles (10) that run at least partly peripherally along the frame (3) and at least one spacer frame (12) that runs peripherally along the hollow profile, parallel to the hollow profiles, and extends over the region of the frame that is not filled with the at least two hollow profiles.

9. A photovoltaic concentrator module according to one of Claims 5 to 8, **characterised in that** the frame (3) or where appropriate the wall of at least one of the at least one hollow profiles (10) and/or where appropriate of at least one of the at least one spacer frames (12) includes at least one opening having at least one filter (9).

10. A photovoltaic concentrator module according to one of the preceding claims, **characterised in that** the frame (3) includes a mounting (13).

11. A photovoltaic concentrator module according to the preceding claim, **characterised in that** the mounting (13) is suitable for mounting and adjusting the photovoltaic concentrator module on a tracking unit.

12. A photovoltaic concentrator module according to one of the preceding claims, **characterised in that** the frame (3) includes at least one electrical connection (14) between the interior (6) of the photovoltaic concentrator module and the exterior.

13. A photovoltaic concentrator module according to the preceding claim, **characterised in that** the at least one electrical connection (14) between the interior (6) of the photovoltaic concentrator module and the exterior is moisture-tight and/or gas-tight.

14. A method for manufacturing a photovoltaic concentrator module according to one of the preceding claims,
**characterised**
**in that** a frame (3) is arranged, in such a way as to connect a lens plate (1) and a base plate (2), along the edge of the lens plate (1) and the base plate (2), and in that there are incorporated to run peripherally along the frame (3) over at least part of its length, between the frame (3) and the lens plate (1) and/or between the frame (3) and the base plate (2), on the one hand at least one first sealing compound (4) and/or adhesive compound (4) and on the other at least one second sealing compound (5),
wherein the two sealing and/or adhesive compounds differ in respect of their curing times and/or gas permeability, and at least one of the at least one first sealing compounds (4) and/or at least one of the at least one second sealing compounds (5) includes or comprises butyl cord and/or elastic silicone.

## Revendications

1. Module concentrateur photovoltaïque
comprenant
une plaque de lentille (1), une plaque de fond (2) sur laquelle des cellules solaires (8) sont disposées et un cadre (3) qui est agencé de façon périphérique le long du bord (111) de la plaque de lentille (1) et de la plaque de fond (2), en reliant la plaque de lentille (1) et la plaque de fond (2),
**caractérisé**
**en ce que**, d'une part, au moins une première masse d'étanchéité (4) et/ou masse de collage (4) et, d'autre part, au moins une deuxième masse d'étanchéité (5) sont agencées de façon périphérique au moins sur une partie de la longueur du cadre (3) le long du cadre (3) entre la plaque de lentille (1) et le cadre (3) et/ou entre la plaque de fond (2) et le cadre (3),
les deux masses d'étanchéité et/ou de collage étant différentes au niveau de leurs temps de durcissement et/ou de leurs perméabilités au gaz et au moins l'une de l'au moins une première masse d'étanchéité (4) et/ou au moins l'une de l'au moins une deuxième masse d'étanchéité (5) présentant un cordon butyl et/ou un silicone élastique ou en étant constituée.

2. Module concentrateur photovoltaïque selon la revendication précédente,
**caractérisé**
**en ce que** le cadre (3) est agencé entre la plaque de lentille (1) et la plaque de fond (2).

3. Module concentrateur photovoltaïque selon la revendication 1,
**caractérisé**
**en ce que** le cadre (3) entoure le bord (111) de la plaque de lentille (1) et/ou de la plaque de fond (2).

4. Module concentrateur photovoltaïque selon l'une des revendications précédentes,
**caractérisé**
**en ce que** l'au moins une première masse d'étanchéité (4) et/ou masse de collage (4) et l'au moins une deuxième masse d'étanchéité (5) sont agencées de façon périphérique respectivement au niveau de la plaque de lentille (1) et au niveau de la plaque de fond (2) et parallèlement l'une à l'autre le long du cadre.

5. Module concentrateur photovoltaïque selon l'une des revendications précédentes,
**caractérisé**
**en ce que** le cadre (3) présente au moins un profilé creux (10) ou en est constitué.

6. Module concentrateur photovoltaïque selon la revendication 5,
**caractérisé**
**en ce qu'**au moins l'un de l'au moins un profilé creux (10) présente des trous vers l'espace intérieur (6) du module.

7. Module concentrateur photovoltaïque selon l'une des revendications 5 et 6,
**caractérisé**
**en ce que** le cadre (3) présente au moins un profilé creux (10) s'étendant au moins partiellement de façon périphérique le long du cadre (3) et au moins un cadre d'écartement (12) s'étendant le long du profilé creux, de façon périphérique parallèlement au profilé creux, dans la zone du cadre qui n'est pas occupée par l'au moins un profilé creux.

8. Module concentrateur photovoltaïque selon l'une des revendications 5 à 7,
**caractérisé**
**en ce que** le cadre (3) présente au moins deux profilés creux (10) s'étendant au moins partiellement de façon périphérique le long du cadre (3) et au moins un cadre d'écartement (12) s'étendant le long du profilé creux, de façon périphérique parallèlement au profilé creux, dans la zone du cadre qui n'est pas occupée par les au moins deux profilés creux.

9. Module concentrateur photovoltaïque selon l'une des revendications 5 à 8,
**caractérisé**
**en ce que** le cadre (3)
ou, le cas échéant, la paroi d'au moins l'un de l'au moins un profilé creux (10) et/ou, le cas échéant, d'au moins l'un de l'au moins un cadre d'écartement (12) présente au moins une ouverture avec au moins un filtre (9).

10. Module concentrateur photovoltaïque selon l'une des revendications précédentes,
**caractérisé**
**en ce que** le cadre (3) présente un support (13).

11. Module concentrateur photovoltaïque selon la revendication précédente,
**caractérisé**
**en ce que** le cadre (13) est approprié pour monter et ajuster le module concentrateur photovoltaïque sur une unité de suiveur.

12. Module concentrateur photovoltaïque selon l'une des revendications précédentes,
**caractérisé**
**en ce que** le cadre (3) présente au moins un raccordement électrique (14) entre l'espace intérieur (6) du module concentrateur photovoltaïque et l'espace extérieur.

13. Module concentrateur photovoltaïque selon la revendication précédente,
**caractérisé**
**en ce que** l'au moins un raccordement électrique (14) entre l'espace intérieur (6) du module concentrateur photovoltaïque et l'espace extérieur est étanche à l'humidité et/ou étanche au gaz.

14. Procédé de fabrication d'un module concentrateur photovoltaïque selon l'une des revendications précédentes,
**caractérisé**
**en ce qu'**un cadre (3) est agencé, en reliant une plaque de lentille (1) et une plaque de fond (2), le long du bord de la plaque de lentille (1) et de la plaque de fond (2), et en ce que, d'une part, au moins une première masse d'étanchéité (4) et/ou masse de collage (4) et, d'autre part, au moins une deuxième masse d'étanchéité (5) sont introduites le long du cadre, de façon périphérique au moins sur une partie de sa longueur, entre le cadre (3) et la plaque de lentille (1) et/ou entre le cadre (3) et la plaque de fond (2),
les deux masses d'étanchéité et/ou de collage étant différentes au niveau de leurs temps de durcissement et/ou de leurs perméabilités au gaz et au moins l'une de l'au moins une première masse d'étanchéité (4) et/ou au moins l'une de l'au moins une deuxième masse d'étanchéité (5) présentant un cordon butyl et/ou un silicone élastique ou en étant constituée.
